(19) **Europäisches Patentamt / European Patent Office / Office européen des brevets**

(11) **EP 4 485 551 A1**

(12) **EUROPEAN PATENT APPLICATION**
published in accordance with Art. 153(4) EPC

(43) Date of publication:
**01.01.2025 Bulletin 2025/01**

(21) Application number: **23760391.5**

(22) Date of filing: **23.02.2023**

(51) International Patent Classification (IPC):
**H01L 31/18** $^{(2006.01)}$     **H01L 31/109** $^{(2006.01)}$
**H01L 31/101** $^{(2006.01)}$

(52) Cooperative Patent Classification (CPC):
**H01L 31/101; H01L 31/109; H01L 31/18**

(86) International application number:
**PCT/KR2023/002577**

(87) International publication number:
**WO 2023/163517 (31.08.2023 Gazette 2023/35)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **23.02.2022 KR 20220023598**
**22.09.2022 KR 20220120023**

(71) Applicant: **Power Cubesemi Inc.**
**Seongnam-si, Gyeonggi-do 13105 (KR)**

(72) Inventors:
• **HONG, Jeong Soo**
**Seongnam-si, Gyeonggi-do 13617 (KR)**
• **KANG, Tai Young**
**Gwangju-si, Gyeonggi-do 12787 (KR)**
• **KANG, Hyun Gi**
**Seoul 05512 (KR)**
• **KYOUNG, Sin Su**
**Hanam-si, Gyeonggi-do 12905 (KR)**
• **RIM, You Seung**
**Seoul 05649 (KR)**

(74) Representative: **Kador & Partner Part mbB**
**Corneliusstraße 15**
**80469 München (DE)**

(54) **SILVER OXIDE/B-GALLIUM OXIDE HETEROJUNCTION-BASED SOLAR BLIND PHOTODETECTOR AND METHOD FOR MANUFACTURING SAME**

(57)     The present invention relates to a heterojunction-based solar blind photodetector. A method for manufacturing a silver oxide/β-gallium oxide heterojunction-based solar blind photodetector may comprise the steps of: growing a first conductive β-gallium oxide epitaxial layer on a first conductive β-gallium oxide wafer; positioning the first conductive β-gallium oxide wafer in a chamber; depositing a second conductive silver oxide layer on the first conductive β-gallium oxide epitaxial layer in a mixed atmosphere of an inert gas and an oxygen gas; blocking oxygen supply to a sputtering chamber; and depositing a silver layer on the second conductive silver oxide layer in an inert gas atmosphere to form a front electrode.

FIG. 10

**Description**

FIELD OF INVENTION

The present invention relates to a heterojunction-based solar blind photodetector

BACKGROUND

Ultraviolet (UV) radiation is extensively used in various areas of human activity, for example, sterilizing bacteria, facilitating the formation of vitamin D, and environmental monitoring. UV light is generally classified into three types according to its wavelength: UVC (280-10 nm), UVB (320-280 nm), and UVA (400-320 nm). In particular, UVC has low noise and interference from other signals in the surrounding area compared to other wavelength signals and is widely used in industrial and safety fields such as warning indicators for partial discharge and in military radar for detecting missiles.
Additionally, deep-ultraviolet (DUV) light with a wavelength of 280 to 200 nm is well known to cause fatal damage to the eyes and skin and accelerate the aging process.5 Therefore, applying a DUV photodetector in practical fields requires a high level of sensing performance, such as fast response speed and high photoresponsivity, selectivity, and stability. Among the various DUV detectors, self-powered photodetectors have been extensively used in numerous civilian, biological, military, astronomy, and environmental monitoring applications because of their excellent reliability, lack of need for an external electrical power source, and efficiency. Photodetectors with semiconductor materials can detect and measure various wavelengths of light based on the photoelectric effect, which transforms the optical signal into electrical signals.
For measuring and detecting UV light, wide band gap semiconductor materials, such as GaN, ZnO, and SiC, and some compound materials, such as $Mg_xZn_{1-x}O$, $Al_xGa_{1-x}N$, $Ga_2O_3$(4.4-5.3 eV), have been used. These materials have high radiation hardness and high chemical and thermal stabilities. However, the UV photodetector based on GaN, ZnO, and SiC cannot selectively respond to DUV light. To detect DUV light with a wavelength of <280 nm, a semiconductor material with an ultrawide band gap of up to 4.42 eV is required. For example, $Mg_xZn_{1-x}O$ and $Al_xGa_{1-x}N$ have been used to construct DUV photodetector materials, and these materials also offered improved response speed and photoresponsivity. However, problems arise in the epitaxial growth of the films; $Mg_xZn_{1-x}O$ with a Mg composition of >37% will induce a phase transition from a wurtzite to rock-salt structure, which generates dislocation and defects with other epitaxial layers and degrades the performance of the detector. $Al_xGa_{1-x}N$ with a high Al component has a difficulty in forming single-crystal films.

DETAILED DESCRIPTION OF INVENTION

TECHNICAL SOLUTION

According to one aspect of the present invention, there is provided a method of manufacturing silver oxide ($Ag_2O$)/β-gallium oxide (β-$Ga_2O_3$) heterojunction based solar blind photodetector. A method for manufacturing a solar blind photodetector based on a silver oxide/β-gallium oxide heterojunction may include growing a first conductivity type β-gallium oxide epitaxial layer on a first conductivity type β-gallium oxide wafer, positioning the first conductivity type β-gallium oxide wafer in a sputtering chamber, depositing a second conductivity type silver oxide layer on the first conductivity type β-gallium oxide epitaxial layer in a mixed atmosphere of an inert gas and an oxygen gas, blocking the supply of oxygen gas to the sputtering chamber, and depositing a silver layer on the second conductivity type silver oxide layer in the inert gas atmosphere to form a top electrode.
In one embodiment, the second conductivity type silver oxide layer and the silver layer may be continuously deposited using a facing target sputtering
In one embodiment, a flow rate of the oxygen gas may be 3 sccm in the depositing the second conductivity type silver oxide layer on the first conductivity type β-gallium oxide epitaxial layer in the mixed atmosphere of the inert gas and the oxygen gas.
In one embodiment, the silver layer may be deposited thicker than a threshold thickness to form a surface uniformly and continuously.
In one embodiment, the silver layer may be deposited thicker than a threshold thickness to form a surface uniformly and continuously.
In one embodiment, the method may further include performing a post-annealing the first conductivity type β-gallium oxide wafer on which the top electrode is formed.
In one embodiment, the post-annealing may be a rapid heat treatment performed at 100°C to 350°C.
According to one aspect of the present invention, there is provided a silver oxide ($Ag_2O$)/β-gallium oxide (β-$Ga_2O_3$) heterojunction based solar blind photodetector. The solar blind photodetector based on a silver oxide/β-gallium oxide heterojunction may include a first conductivity type β-gallium oxide wafer, a first conductivity type β-gallium oxide epitaxial layer, epitaxially grown on a top surface of the first conductivity type β-gallium oxide wafer, a second conductivity type silver oxide layer, deposited on the first conductivity type β-gallium oxide epitaxial layer in a mixed atmosphere of an inert gas and an oxygen gas, a silver layer, deposited on the second conductivity type silver oxide layer in the inert gas atmosphere, and a bottom electrode layer in ohmic contact with a bottom surface of the first conductivity type β-gallium oxide wafer.

In one embodiment, the silver layer may be formed by continuously depositing on the second conductive type silver oxide layer by blocking the supply of oxygen gas to a sputtering chamber after deposition of the second conductive type silver oxide layer.

In one embodiment, the second conductive type silver oxide layer may have a thickness of 50nm.

In one embodiment, the silver layer may be deposited with a thickness of 20nm to increase a transmittance and decrease a reflectance.

BRIEF DESCRIPTION OF DRAWINGS

Hereinafter, embodiments of the invention will be described with reference to the accompanying drawings. For the purpose of easy understanding of the invention, the same elements will be referred to by the same reference signs. Configurations illustrated in the drawings are examples for describing the invention, and do not restrict the scope of the invention. Particularly, in the drawings, some elements are slightly exaggerated for the purpose of easy understanding of the invention. Since the drawings are used to easily understand the invention, it should be noted that widths, depths, and the like of elements illustrated in the drawings might change at the time of actual implementation thereof. Meanwhile, throughout the detailed description of the invention, the same components are described with reference to the same reference numerals.

FIG. 1 exemplarily illustrates a silver oxide/β-gallium oxide heterojunction based solar blind photodetector;

FIG. 2 is a flow chart exemplarily illustrating a process for forming a silver oxide/β-gallium oxide heterojunction;

FIG. 3A to FIG. 3D are SEM plain view images of a Ag layer deposited on a glass substrate;

FIG. 4 is a graph exemplarily showing an X-ray diffraction pattern of the Ag layer deposited on a glass substrate;

FIG. 5 is a graph exemplarily showing an optical properties of the Ag layer deposited on the glass substrate;

FIG. 6A to FIG. 6E are AFM images showing the surface of the Ag layer deposited on the glass substrate;

FIG. 7 is a graph exemplarily showing an X-ray diffraction patterns of Ag layers according to post-annealing temperatures;

FIG. 8 is a graph exemplarily showing an X-ray diffraction pattern of an $Ag_2O$ layer according to an oxygen flow rate;

FIG. 9 is a graph exemplarily showing an X-ray diffraction pattern of the $Ag_2O$ layer according to the post-annealing temperature;

FIG. 10 is a graph exemplarily showing an ideal band gap energy of the $Ag_2O$ layer;

FIG. 11 is a graph exemplarily showing an UV-vis transmittance spectrum of the $Ag_2O$ layer;

FIG. 12 is a graph showing a J-V characteristic of the silver oxide/β-gallium oxide heterojunction-based photodetector according to the thickness of the Ag layer;

FIG. 13 is a graph showing a change in electrical parameters of a silver oxide/β-gallium oxide heterojunction-based photodetector according to the thickness of the Ag layer;

FIG. 14 exemplarily shows a band diagram of a silver oxide/β-gallium oxide heterojunction;

FIG. 15 exemplarily shows a band diagram of an $Ag/Ag_2O$ junction according to the thickness of the silver layer;

FIG. 16 is a graph showing a time-dependent photocurrent density of a silver oxide/β-gallium oxide heterojunction-based photodetector according to the thickness of the silver layer;

FIG. 17 is a graph showing a time-dependent photocurrent density of the silver oxide/β-gallium oxide heterojunction-based photodetector according to UV wavelength;

FIG. 18 is a graph showing a responsivity of the silver oxide/β-gallium oxide heterojunction-based photodetector according to UV wavelength;

FIG. 19 is a graph showing a detectivity of the silver oxide/β-gallium oxide heterojunction-based photodetector according to UV wavelength;

FIG. 20 and FIG. 21 are graphs showing rise time and fall time of the time-dependent photocurrent of the photodetector, respectively;

FIG. 22 is a graph showing the results of a photostability test performed on a pristine photodetector and a photodetector stored for three months; and

FIG. 23 is a graph showing the results of the photostability test performed on a photodetector stored for three months.

MODE FOR INVENTION

Embodiments which will be described below with reference to the accompanying drawings can be implemented singly or in combination with other embodiments. But this is not intended to limit the present invention to a certain embodiment, and it should be understood that all changes, modifications, equivalents or replacements within the spirits and scope of the present invention are included. Especially, any of functions, features, and/or embodiments can be implemented independently or jointly with other embodiments. Accordingly, it should be noted that the scope of the invention is not limited to the embodiments illustrated in the accompanying drawings.

Terms such as first, second, etc., may be used to refer to various elements, but, these element should not be limited due to these terms. These terms will be used to distinguish one element from another element.

The terms used in the following description are intended to merely describe specific embodiments, but not intended to limit the invention. An expression of the singular number includes an expression of the plural number, so long as it is clearly read differently. The terms such as "include" and "have" are intended to indicate that features, numbers, steps, operations, elements, components, or combinations thereof used in the following description exist and it should thus be understood that the possibility of existence or addition of one or more other different features, numbers, steps, operations, elements, components, or combinations thereof is not excluded.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present.

Spatially relative terms, such as "beneath," "below," "lower," "above," "upper," and the like, may be used herein for descriptive purposes, and, thereby, to describe one element or feature's relationship to another element(s) or feature(s) as illustrated in the drawings. Spatially relative terms are intended to encompass different orientations of an apparatus in use, operation, and/or manufacture in addition to the orientation depicted in the drawings.

Hereinafter, embodiments of the present invention will be described in detail with reference to the accompanying drawings.

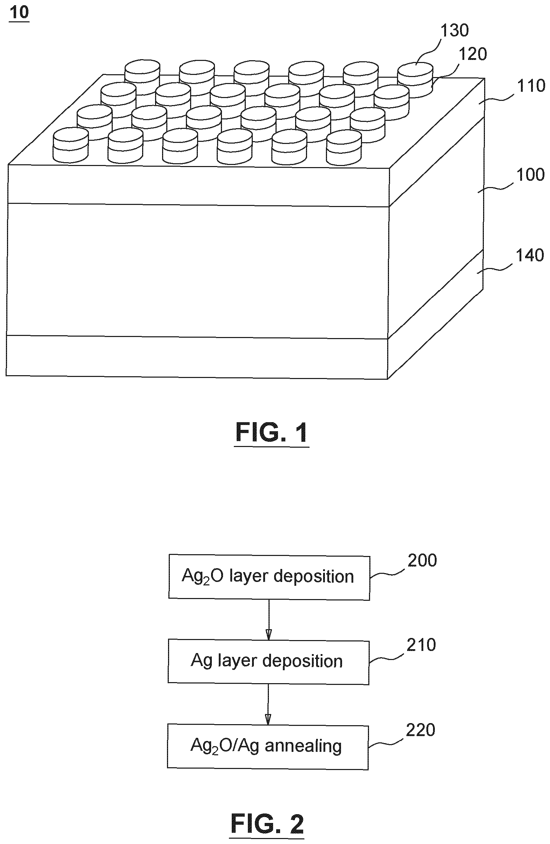

FIG. 1 exemplarily illustrates a silver oxide/β-gallium oxide heterojunction based solar blind photodetector.

Referring to FIG. 1, a solar blind photodetector 10 may include a first conductivity type gallium oxide wafer 100, a first conductivity type gallium oxide ($\beta$-$Ga_2O_3$) epitaxial layer 110, a silver oxide ($Ag_2O$) layer 120, a silver (Ag) layer 130, and a bottom electrode layer 140. The first conductivity type may be n-type.

The first conductivity type gallium oxide wafer 100 may be formed of single-crystal β-gallium oxide ($\beta$-$Ga_2O_3$) doped with a first conductivity type dopant. A β-gallium oxide can be easily formed into a bulk single crystal at a relatively low cost compared to other ultra-wide bandgap materials. In addition, β-gallium oxide has excellent thermal and chemical stability, and has an ultra-wide bandgap of about 4.4 to about 4.8 eV even without doping or alloying. The first conductivity type dopant may be, for example, tin (Sn) or silicon (Si), and the concentration of the first conductivity type dopant $N_d$-$N_a$ may be about $5.8 \times 10^{18} cm^{-3}$. Meanwhile, the thickness of the firstchallenge type gallium oxide wafer 100 may be about $640\mu m$.

The first conductivity type gallium oxide epitaxial layer 110 may be a β-gallium oxide doped with a first conductivity type dopant epitaxially grown on a top surface of a first conductivity type gallium oxide wafer 100. The first conductivity type dopant may be, for example, silicon (Si), and a concentration of the first conductivity type dopant may be about $2.0 \times 10^{16} cm^{-3}$. Meanwhile, a thickness of the first conductivity type gallium oxide epitaxial layer 110 may be about $9.2 \mu m$. The first conductivity type gallium oxide epitaxial layer 110 may be deposited by, for example, HVPE (Halide vapor phase epitaxy), MOCVD (Metalorganic chemical vapor deposition), Mist CVD, MBE (Molecular Beam Epitaxy), PLD (Pulsed laser deposition).

The bottom electrode layer 140 may be an ohmic contact layer formed on the bottom surface of the first conductivity type gallium oxide wafer 100. The bottom electrode layer 140 may be formed by, for example, sequentially depositing titanium (Ti) and gold (Au) on the bottom surface of the first conductivity type gallium oxide wafer 100 by electron-beam evaporation. The thickness of the Ti layer may be about 10nm, and the thickness of the Au layer may be about 40nm.

The $Ag_2O$ layer 120 may be deposited on the first conductivity type gallium oxide epitaxial layer 110 and may have a second conductivity type. The second conductivity type may be p-type. The Ag layer 130 may be a top electrode layer formed on the $Ag_2O$ layer 120. Most photodiodes use a metal layer as the top electrode. Metal layers such as copper (Cu), silver (Ag), and gold (Au) have been widely used due to their excellent electrical conductivity and optical performance. However, gold is an expensive material and copper is easily oxidized in the air. Therefore, among these materials, the Ag layer 130 is suitable for an electrode in optoelectronics and is widely used. The properties of the Ag layer 130 generally depend on its thickness. As the thickness of the Ag layer 130 increases, the surface structure becomes rougher, and the rough surface can cause optical loss due to scattering of light.

The $Ag_2O$ layer 120 and the Ag layer 130 may be formed continuously by a single sputtering process, for example, facing target sputtering (FTS), which enables the formation of high-quality $Ag_2O$ layer 120 and Ag layer 130 through a high ionization rate with less damage to the substrate from the plasma. The $Ag_2O$ layer 120 may be formed by reactive sputtering that reacts Ag with oxygen gas ($O_2$). Silver can form various phases such as $Ag_2O$, $AgO$, $Ag_2O_3$, $Ag_3O_4$ by interacting with $O_2$. Among them, $Ag_2O$ has a cubic structure like $Cu_2O$ and, in general, reveals p-type semiconducting properties. In this specification, silver oxide is used to refer to $Ag_2O$.

The $Ag_2O$ layer 120 and the Ag layer 130 may be patterned by a shadow mask, and in the illustrated structure, they may be formed in a circular shape with a radius of about $300\mu m$. The thickness $T_{ag2o}$ of the $Ag_2O$ layer 120 may be about 50nm, and the thickness $T_{ag}$ of the Ag layer 130 may be about 20% to about 80% of the $T_{ag2o}$. When the thickness $T_{ag2o}$ of the $Ag_2O$ layer 120 is 50nm or more, it can be converted into the Ag layer instead of an oxide. Therefore, the maximum thickness that can maintain the oxide is about 50nm.

FIG. 2 is a flow chart exemplarily illustrating a process for forming a silver oxide/β-gallium oxide heterojunction.

In step 200, the first conductivity type gallium oxide wafer 100 on which the first conductivity type gallium oxide epitaxial layer 110 is formed is placed in a chamber of the FTS. The shadow mask for patterning the $Ag_2O$ layer 120 and the Ag layer 130 is placed on the first conductivity type gallium oxide epitaxial layer 110. By the shadow mask, a plurality of circular $Ag_2O$ layers 120 having the radius of about $300\mu m$ and spaced apart from each other may be deposited on the first conductivity type gallium oxide epitaxial layer 110. In a chamber to which a working pressure of about 2mTorr is applied, the reactive sputtering using a silver target is performed in a mixed atmosphere of oxygen gas and an inert gas, for example, argon.

Table 1

| Parameters | Condition | |
|---|---|---|
| Layer | $Ag_2O$ | Ag |
| Target | Ag(99.99%) | Ag(99.99%) |
| Basic pressure | $3 \times 10^{-5}$Torr | $3 \times 10^{-5}$Torr |
| Working pressure | 2mTorr | 2mTorr |
| Gas flow | Ar: 10sccm, O2: 3sccm | Ar: 10sccm |
| Input power | 50W(DC) | 15W(DC) |
| Thickness | 50nm | 10, 20, 30, 40nm |

In step 210, when the thickness $T_{ag2o}$ of the $Ag_2O$ layer 120 becomes about 50nm, sputtering using a silver target is continuously performed, but the oxygen gas supply is stopped and the sputtering is performed in an argon atmosphere. As a result, the Ag layer 130 may be continuously deposited on the $Ag_2O$ layer 120. The working pressure and the gas flow rate of argon are the same as the working pressure and the gas flow rate in the formation process of the $Ag_2O$ layer 120, while the input power applied to the formation of the Ag layer 130 may be smaller than the input power applied to the formation of the Ag$_2$O layer 120. The sputtering time may be adjusted so that the thickness T$_{ag}$ of the Ag layer 130 becomes about 20% to about 80% of the T$_{ag2o}$. The continuous deposition of the Ag$_2$O layer and the Ag layer using FTS can significantly reduce defects occurring in the deposited layers and the time required for the process. If the chamber is opened to deposit another metal layer after the Ag$_2$O layer is deposited, the layer deposition conditions change and impurities may flow into the chamber. On the other hand, if the Ag layer is continuously deposited after the Ag$_2$O layer is deposited, there are no needs to open the chamber, so not only can the layer deposition conditions be stably maintained, but the impurity concentration can also be low. In addition, the Ag$_2$O layer and the Ag layer formed by the continuous deposition using FTS are of the same series of materials, so the adhesion between the two layers is very excellent. In step 220, the first conductivity type gallium oxide wafer 100 formed up to the Ag layer 130 may be post-annealed. The post-annealing may be a rapid thermal annealing performed at about 100°C to about 400°C for about 1 minute at a pressure of about 100mTorr in an argon atmosphere. Preferably, the rapid thermal annealing temperature may be about 300°C to about 350°C.

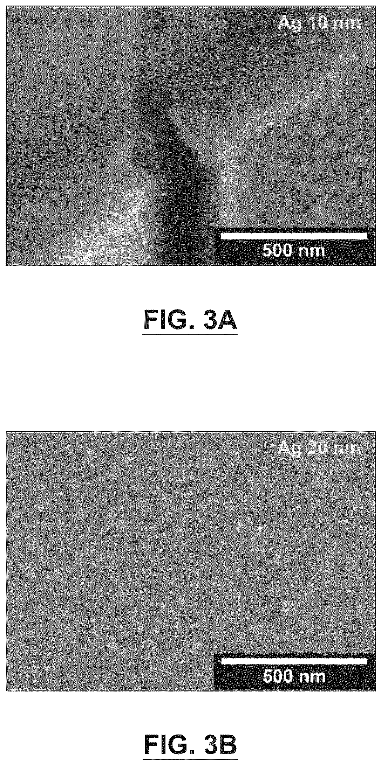

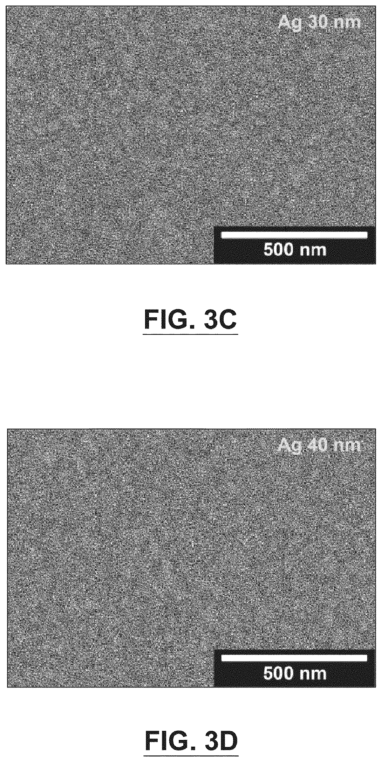

FIG. 3A to FIG. 3D are SEM plain view images of an Ag layer deposited on a glass substrate.

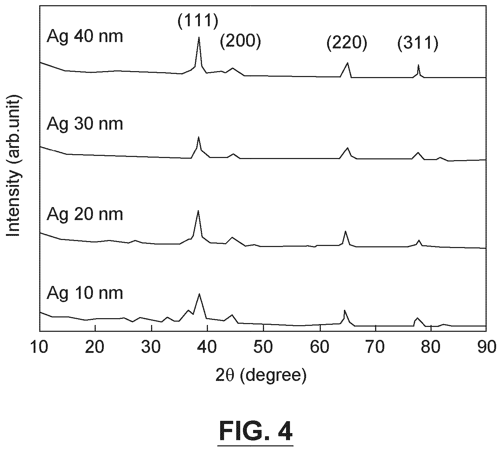

The thickness T$_{ag}$ of the Ag layer increased from about 10nm by about 10nm. As shown in the SEM image of FIG. 3A, the Ag layer with a thickness of about 10nm did not form a uniform surface. Metal-based thin films grown on substrates generally undergo several steps in a procedure, such as nucleation, coalescence, and thickness growth. The initial growth of metal forms isolated three-dimensional islands according to the Volmer-Weber mode owing to the low adhesion of metal films. Because of these properties, the metal film on the substrate has a threshold thickness; the threshold thickness is generally ~10 - 15nm, which is the minimum thickness that can be fabricated as a continuous film. The SEM images in FIGS. 4B through 4D of Ag layers above the threshold thickness (20nm - 40nm) reveal homogeneous surfaces and continuous film forms. Non-continuous and inhomogeneous layers are expected to affect photoresponsivity owing to their high light reflection or scattering by a rough surface morphology, especially when the 10 nm Ag layer is applied to the photodetector.

FIG. 4 is a graph exemplarily showing an X-ray diffraction pattern of the Ag layer deposited on a glass substrate.

When the crystallographic properties were measured using an X-ray diffractometer (SmartLab, Rigaku), the Ag layer exhibited a polycrystalline structure. The Ag peaks appearing at $2\theta = 38.5°, 44.8°, 64.9°$, and $77.7°$ correspond to the (111), (200), (220), and (311) planes, respectively (ICDD card 01-087-0720). Dramatic changes according to the thickness of the Ag layer were not observed in the XRD pattern.

The Scherrer equation was used to calculate the crystallite sizes according to the thickness of Ag films at the (111) plane, as follows

Mathematical equation 1

$$\tau = \frac{K\lambda}{\beta\cos\theta}$$

Where, $\beta$ is the full width at half-maximum (FWHM), $\tau$ is the crystallite size, $\lambda$ is the X-ray wavelength (0.15406 nm), $\theta$ is the Bragg angle, and $K$ is the Scherrer constant (0.9)[2]. As summarized in Table 2, it was confirmed that the crystallite size increases with the film thickness.

Table 2

| Thickness of Ag layer | Crystallite size |
|---|---|
| 10nm | 16.3nm |
| 20nm | 16.6nm |
| 30nm | 17.9nm |
| 40nm | 20.0nm |

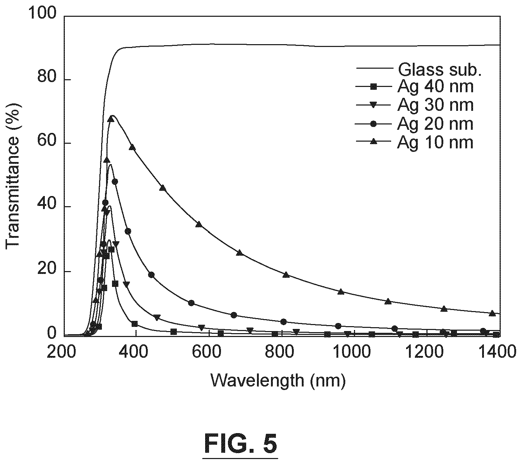

FIG. 5 is a graph exemplarily showing an optical properties of the Ag layer deposited on the glass substrate.

Referring to FIG. 5, the transmittance of the Ag layer shows a tendency to decrease as the thickness T$_{ag}$ increases. The transmittance of the Ag layer, which starts to increase from a wavelength of about 260nm, starts to decrease around a wavelength of about 320nm. The maximum transmittance by thickness T$_{ag}$ at a wavelength of about 320nm decreases as the thickness T$_{ag}$ increases. Therefore it can be confirmed that a reflectivity decreases as the thickness T$_{ag}$ decreases, resulting in less optical loss.

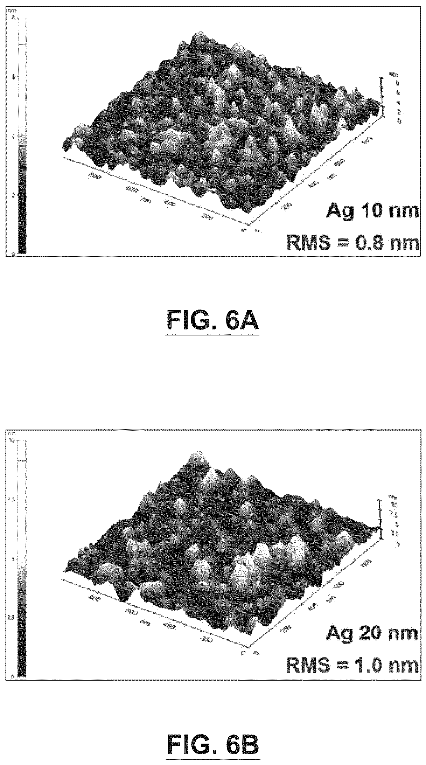

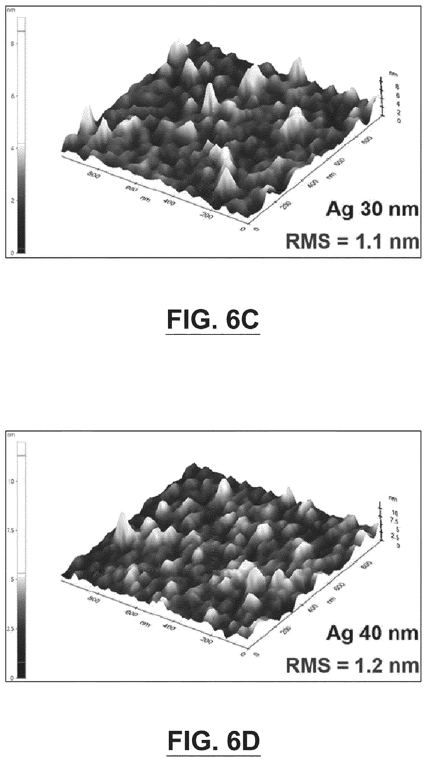

FIG. 6A to FIG. 6E are AFM images showing the surface of the Ag layer deposited on the glass substrate.

FIGS. 6A to 6D show the surfaces of Ag layers with thicknesses of about 10nm, about 20nm, about 30nm, and about 40nm, obtained using AFM with a scan area of $1 \times 1\mu m^2$. All samples exhibit uniform and smooth surface morphologies. The rootmean-square (RMS) surface roughness ranges from about 0.8nm to about 1.2nm for the Ag layers with thicknesses of about 10nm to about 40nm. The RMS surface roughness increases monotonically with increasing thickness of the Ag layers.

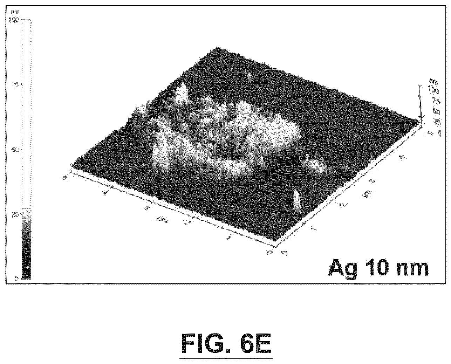

On the other hand, FIG. 6E shows the surface of the Ag layer with thicknesses of about 10nm, obtained using AFM with a scan area of $5 \times 5 \ \mu m^2$. When the scan area is enlarged, it can be seen that the Ag layer exhibit an inhomogeneous structure and rough surface. The RMS surface roughness of the Ag layer with thicknesses of about 10nm was about 5.9nm. This is because the Ag was deposited at the thickness of about 10nm, which is lower than the threshold thickness required for forming a continuous thin film. Because the rough surface morphology of the top electrode thin film causes optical losses such as reflection or scattering, these losses could adversely affect the photoresponse properties.

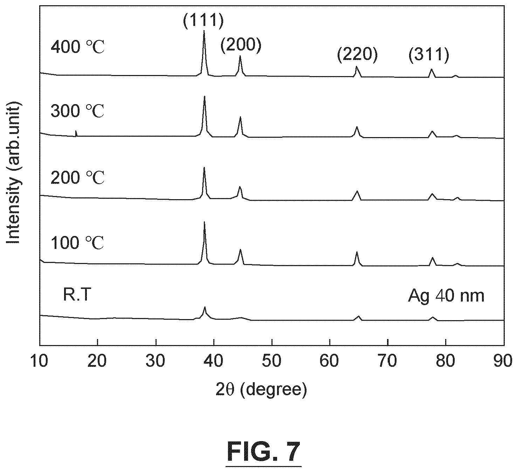

FIG. 7 is a graph exemplarily showing an X-ray diffraction patterns of Ag layers according to post-annealing temperatures.

The effect of post-annealing on the Ag layers can be confirmed by X-ray diffraction patterns obtained from samples post-annealed at various temperatures. The Ag layer with a thickness of about 40nm was annealed at about 100°C to about 400°C. It can be seen that the crystallinity of the Ag layer was improved by post-annealing. When comparing the Ag layer that was not annealed and the Ag layer that was post-annealed, it can be seen that the annealed Ag layer exhibited relatively high peak intensity. On the other hand, no significant change in the X-ray diffraction patterns was observed between the Ag layers that were annealed at different temperatures. In other words, it can be seen that the post-annealing temperature does not significantly affect the properties of the Ag layer. Increasing the annealing temperature contributed to the reduction of interfacial defects or traps by removing surface contamination and reducing oxygen vacancies

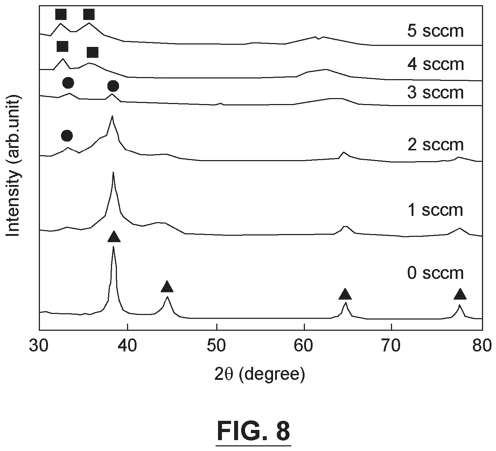

FIG. 8 is a graph exemplarily showing an X-ray diffraction pattern of an $Ag_2O$ layer according to an oxygen flow rate.

Referring to FIG. 8, XRD patterns of $Ag_2O$ layers deposited by changing the oxygen flow rate in the range of 0 sccm to about 5 sccm are shown. Here, • indicates an $Ag_2O$ peak, ▲ indicates an Ag peak, and ■ indicates an AgO peak, respectively. At an oxygen flow rate of 0 sccm, according to reference data (ICDD card 01-087-0720), Ag peaks appear at $2\theta = 38.2°, 44.4°, 64.6°$, and $77.6°$, which correspond to the (111), (200), (220), and (311) planes, respectively. At an oxygen flow rate of about 2 sccm, the intensity of the Ag peak decreases and the (100) plane of $Ag_2O$ (ICDD card 01-072-2108) appears additionally at $2\theta = 33.6°$, indicating a mixed phase of $Ag_2O$ and Ag. In addition, at an oxygen flow rate of about 3 sccm, broad peaks representing the (100) and (011) planes of $Ag_2O$ appear at $2\theta = 33.6°$ and $38.4°$ without other impurities. As the oxygen flow rate increases from about 4 sccm to about 5 sccm, the $Ag_2O$ peak disappears and new peaks corresponding to AgO (JCPDS card 75-0969) appear at $2\theta = 32.3°$ and $35.6°$. As the oxygen flow rate increases, additional chemical bonds between Ag and O are formed, resulting in the generation of the AgO peak. Therefore, the oxygen flow rate may be adjusted between about 2 sccm and about 4 sccm, and preferably about 3 sccm.

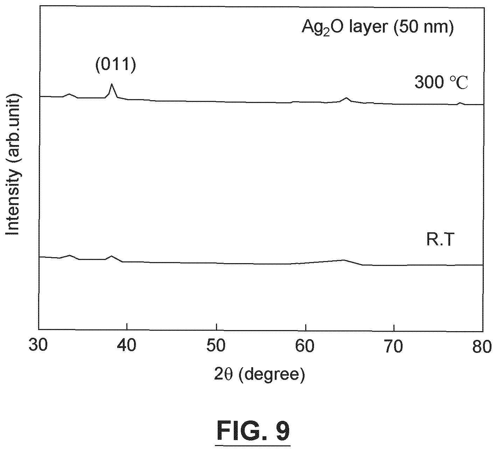

FIG. 9 is a graph exemplarily showing an X-ray diffraction pattern of the $Ag_2O$ layer according to the post-annealing temperature.

The electrical properties of the $Ag_2O$ layer can be measured by Hall measurement (carrier concentration $6.35 \times 10^{18} cm^{-3}$, mobility $61.4 cm^2/Vs$, resistance $1.38 \times 10^{-2} \Omega \cdot cm$). The measurement results indicate that the $Ag_2O$ layer is a p-type semiconductor. The effect of the post-annealing process and the optical properties of the $Ag_2O$ layer were also measured using a thin film about 50nm thick deposited on a glass substrate. As shown in Fig. 9, the X-ray diffraction pattern of the $Ag_2O$ layer about 50nm thick deposited on the glass substrate was measured at room temperature (without post-annealing) and post-annealed at about 300°C. The $Ag_2O$ peaks appearing at $2\theta=33.6°$ and $38.4°$ correspond to the (100) and (011) planes, respectively (ICDD Card 01-072-2108). Compared with the as fabricated (namely, not-annealed) $Ag_2O$ layer, the $Ag_2O$ peak intensity is maximum at a post-annealing temperature of approximately 300°C, indicating an improvement in the crystallinity without any crystal transition.

Meanwhile, according to "The thermal decomposition of silver (I, III) oxide: A combined XRD, FT-IR and Raman spectroscopic study" Waterhouse et al., Chemistry Physical Chemistry Chemical Physics, 2001, 3, 3838-3845, when the annealing temperature increases to about 350°C or higher, the $Ag_2O$ film can be transformed into the Ag film. In particular, when the annealing temperature increases to about 400°C or higher, the intensity of the $Ag_2O$ (100) peak significantly decreases, and the intensities of the (200), (220), and (311) peaks increase. This indicates that a portion of the $Ag_2O$ layer annealed at about 400°C is transformed into Ag, and the $Ag_2O$ and Ag are in a mixed state. The transition from $Ag_2O$ to Ag is because the diffusion rate of Ag increases due to the thermal effect, and the diffusion rate of oxygen becomes relatively smaller than that of Ag. Therefore, sufficient heat energy increases the diffusion of Ag, thereby breaking the chemical bond with oxygen. Since the performance of the device may be degraded when the $Ag_2O$ is decomposed into Ag, the post-annealing may be performed at about 350°C or lower, preferably about 300°C, to improve the surface condition.

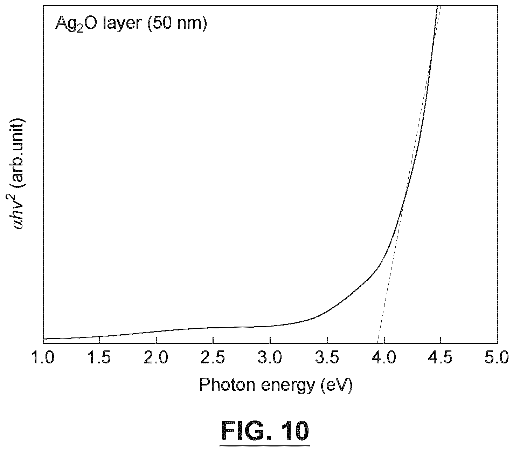

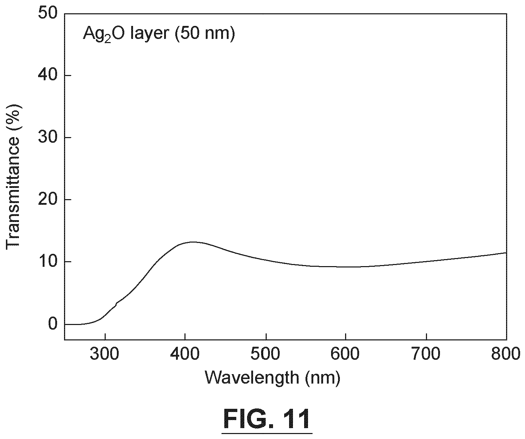

FIG. 10 is a graph exemplarily showing an ideal band gap energy of the $Ag_2O$ layer, and Fig. 11 is a graph exemplarily showing an UV-vis transmittance spectrum of the $Ag_2O$ layer.

The optical band gap energy of the $Ag_2O$ layer deposited by reactive sputtering with an argon flow rate of about 10 sccm and an oxygen flow rate of about 3 sccm is exemplarily shown in FIG. 10. The optical band gap energy of the $Ag_2O$ layer can be calculated using the Tauc plot equation, under the assumption that the absorption product is given by

### Mathematical equation 2

$$\alpha h v = \alpha_0 (h v - E_g)^n$$

where, $\alpha_o$ is a material constant, $hv$ is the photon energy ($=1240/\lambda$), $E_g$ is the optical band gap energy, and $n$ is the power coefficient, which can be 1/2, 3/2, 2, or 3 depending on the type of transition (direct allowed, direct forbidden, indirect allowed, or indirect forbidden, respectively). Because the $Ag_2O$ film has a direct allowed transition, n = 1/2 was used to calculate the optical band gap energy. The optical band gap value obtained was 3.95 eV. The UV-vis spectra of the as fabricated $Ag_2O$ layer on the glass substrate is shown in FIG. 11

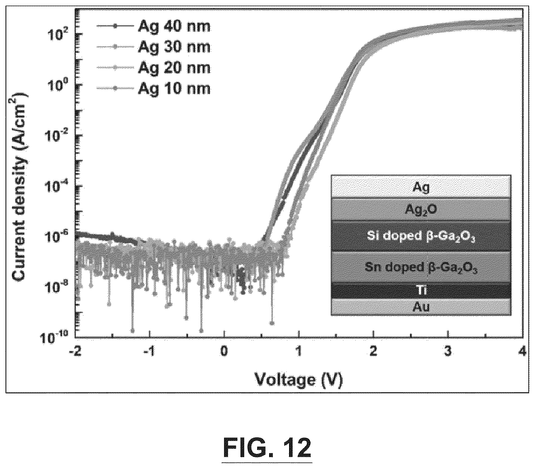

FIG. 12 is a graph showing a J-V characteristic of the silver oxide/β-gallium oxide heterojunction-based photodetector according to the thickness of the Ag layer.

Referring to FIG. 12, the J-V characteristic curves of the silver oxide/β-gallium oxide heterojunction-based photodetector with different thicknesses of the Ag layers are shown as measured in the dark in the range of about -2 V to 4 V. Regardless of the thickness of the Ag layer, the rectification characteristics of the p-n junction were confirmed in all photodetectors. An off-current of the photodetector with the Ag layer of about 10nm in thickness is low, about $9.28 \times 10^{-8}$ A/cm$^2$ (about $6.55 \times 10^{-11}$ A), and an on-current is about 31.84A/cm$^2$ (about $2.25 \times 10^{-2}$ A). Namely, the photodetector with the Ag layer of about 10nm in thickness has a high on-off ratio of about $3.43 \times 10^8$. Additionally, the J-V characteristics indicate that the leakage current increases with the increasing thickness of the Ag layer. Because the smooth film could effectively reduce the carrier scattering center and suppress interface charge traps, it could be considered that thin Ag layers, which have a relatively smooth surface morphology, have fewer traps or dislocations at the interface between the Ag layer and the $Ag_2O$ layer. Accordingly, this induces a decrease in the leakage current under the reverse bias.

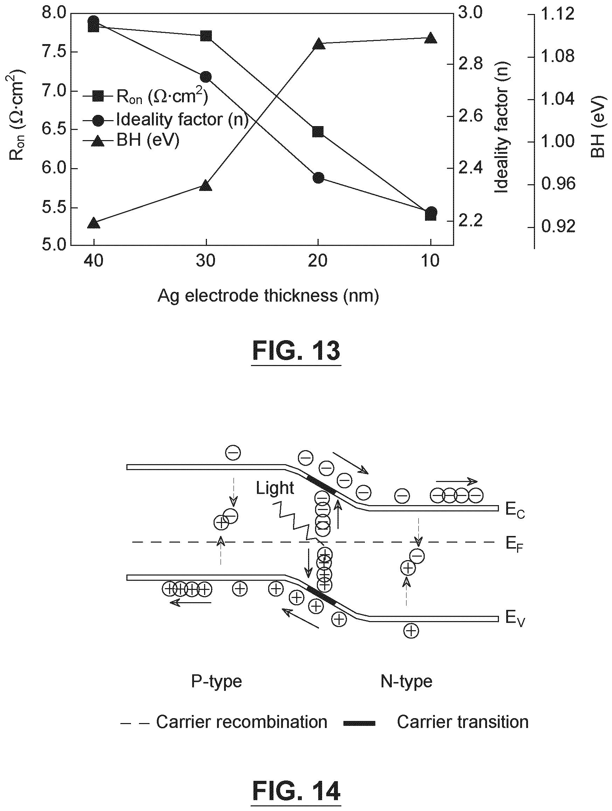

FIG. 13 is a graph showing a change in electrical parameters of a silver oxide/β-gallium oxide heterojunction-based photodetector according to the thickness of the Ag layer.

Referring to FIG. 13, an on-resistance $R_{on}$, ideality factor n, and a barrier height BH according to the thickness of the Ag layer are illustrated. These parameters can be calculated from the J-V curve of the p-n junction photodetector based on the thermionic emission model as follows:

### Mathematical equation 3

$$J = J_S \exp\left\{ \frac{q(V - IR_S)}{nkT} \right\}$$

where $Js$ is a saturation current density, $q$ is the electron charge, $V$ is a voltage across the diode, $R_s$ is a series resistance, $n$ is the ideality factor that represents the deviation between the ideal diode and the practical diode in the presence of barrier inhomogeneity and the tunneling component, $k$ is the Boltzmann constant, and $T$ is the temperature in kelvin.

$J_s$ is given by:

### Mathematical equation 4

$$J_s = AA^{**}T^2 \exp\left( \frac{-q\phi_B}{kT} \right)$$

where A* is the Richardson constant (41A/(cm$^2$K$^2$) for [3-$Ga_2O_3$), A is the contact area, q is the electron charge, $\varphi_B$ is the effective barrier height, k is the Boltzmann constant, and $T$ is the temperature in kelvin.

The values of $R_{on}$ and the ideality factor n decreased with decreasing Ag layer's thickness (from 40 to 10 nm), dropping from 7.83 to 5.40 mΩ·cm$^2$ for $R_{on}$ and from 2.97 to 2.23 for the ideality factor n. The decrease in $R_{on}$ and the ideality factor n was related to the condition of the interface between the Ag layer and the $Ag_2O$ layer. There is a positive correlation between $R_{on}$ and dislocations. These results indicate that the dislocation and defect states at the interface of the Ag/$Ag_2O$ increased as the thickness of the Ag layer increased. As a result, these defects captured carriers or interrupted their movement, thereby increasing the resistance. Therefore, thin Ag layer with low surface roughness have a lower defect density at the Ag/Ag2O interface, as mentioned above. However, the barrier height increased from 0.92 to 1.10 eV with a decrease in the thickness of the Ag layer. This could be attributed to the reduction in interfacial defects with decreasing thickness and roughness of the Ag layer. The presence of defects in the interfacial layer can capture and restrain the movements of charge carrier. In this case, the electrical fields which generated by Fermi level mismatch of each layer at the interface are reduced. According to Gauss's law, the depletion layers of $Ag_2O/\beta$-$Ga_2O_3$ and $Ag/Ag_2O$ junctions with interfacial defects become narrower than the ideal depletion layer, which did not have an interfacial defect. The high value of the ideality factor and hump phenomenon of the as fabricated photodetector from the J-V curve (especially, photodetectors fabricated with 30nm and 40nm Ag layers) would be influenced by interface charge traps, thermionic emission, and carrier recombination.

FIG. 14 exemplarily shows a band diagram of a silver oxide/β-gallium oxide heterojunction.

The photocurrent generation on the p-n junction-based photodetectors is related to the properties of the depletion region. Before forming the p-n junction, the Fermi level of the n-type semiconductor exists near the conduction band, while that of the p-type semiconductor is located around the valance band.

Referring to FIG. 14, when a p-type semiconductor forms a junction with an n-type semiconductor, the Fermi level of each type is aligned, causing band bending. Moreover, free electrons, the major n-type carriers, diffuse into the positively charged p-type holes and combine with holes. Conversely, the positive holes located in the p-type diffuse into the n-type, resulting in the neutralization of the net charge. When the diffused electrons and holes reach equilibrium, a charge-neutralized region, known as the depletion layer, is formed. The energy barrier constructed by bending and the depletion layer is important for self-powered devices. The photocurrent is increased by the charge carriers generated by light irradiation. When light irradiates the photodetector, the energy of light generates EHPs at the interface of the $Ag_2O/\beta$-$Ga_2O_3$ p-n junction. These charge carriers generated by the light would increase the photocurrent; therefore, the number of precombined carriers in the deletion layer is directly related to the photocurrent. Additionally, at zero bias, the photogenerated EHPs in the depletion layer become rapidly separated by the built-in electric field; the electrons transfer to the n-type and holes to the p-type, and the photogenerated EHPs are more effectively and quickly separated with a higher energy barrier.

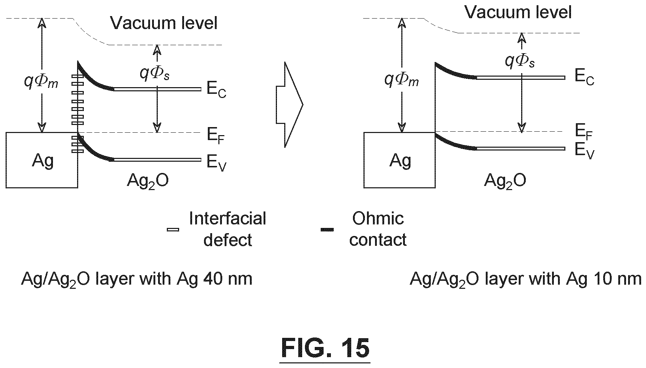

FIG. 15 exemplarily shows a band diagram of an $Ag/Ag_2O$ junction according to the thickness of the silver layer.

Referring to FIG. 15, the $Ag/Ag_2O$ junction with a large number of interfacial traps exhibits the Fermi-level pinning at the $Ag/Ag_2O$ interface. This can block the electrical response of the $Ag/Ag_2O$ junction. However, the $Ag/Ag_2O$ layer with thin Ag layer, which has a small number of interfacial traps, reveals an unpinned Fermi level and attains more stable and reliable electrical contact than thick films.

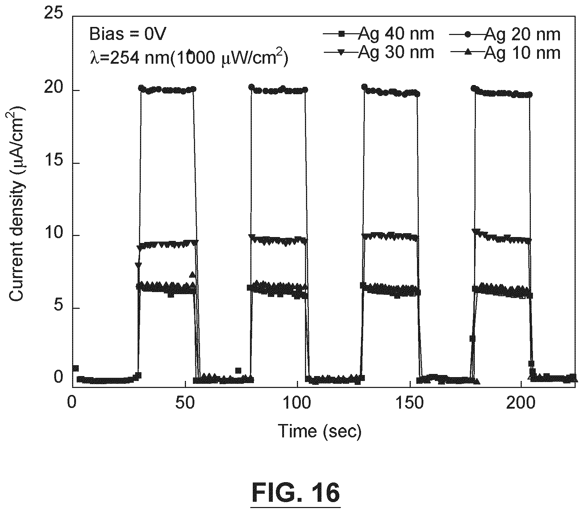

FIG. 16 is a graph showing the time-dependent photocurrent density of the silver oxide/β-gallium oxide heterojunction-based photodetector according to the thickness of the silver layer, where the time-dependent photocurrent density of the photodetectors fabricated using silver layers of thicknesses of about 10nm, about 20nm, about 30nm, and about 40nm is shown under UV with a wavelength of about 254 nm at zero bias.

Referring to FIG. 16, the photocurrent density increased as the thickness of Ag decreased until about 20nm, indicating that the highest photocurrent density of $20.0\mu A/cm^2$ was achieved for the photodetector deposited with the 20nm Ag layer. Because the thin Ag layer has low surface roughness, the optical loss on the surface of the Ag layer is relatively low; therefore, the photocurrent is expected to increase. However, as seen in the AFM image of the 10nm layer in FIG. 6E, the 10nm layer did not form a homogeneous and continuous film. Consequently, the photogenerated current would be low because of the large amount of light scattering and reflection on the Ag layer surface. Every photodetector rapidly flowed photocurrent as the UV light was turned on, revealing high reproducibility by keeping the photocurrent constant; the moment that the UV light was turned off, the photocurrent fell to the dark current.

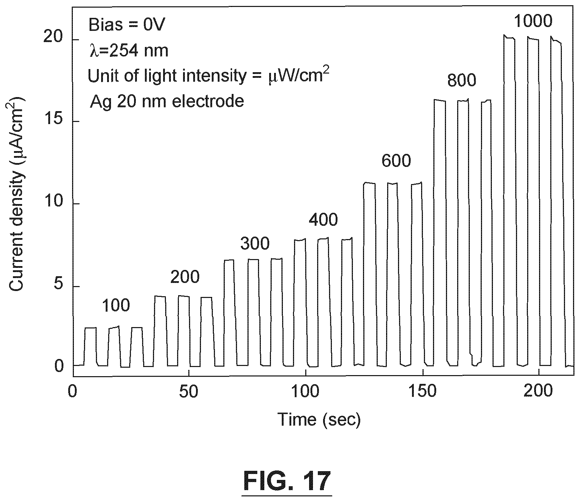

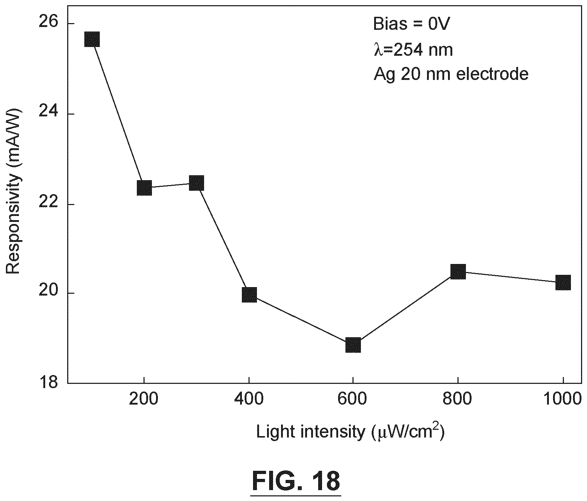

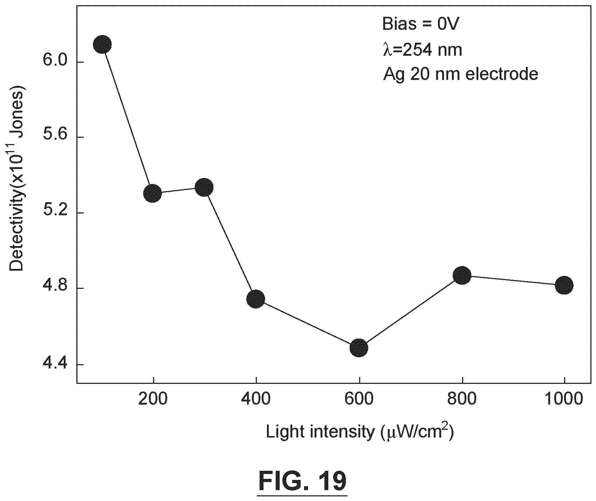

FIG. 17 is a graph showing a time-dependent photocurrent density of the silver oxide/β-gallium oxide heterojunction-based photodetector according to UV wavelength, FIG. 18 is a graph showing a responsivity of the silver oxide/β-gallium oxide heterojunction-based photodetector according to UV wavelength, and FIG. 19 is a graph showing a detectivity of the silver oxide/β-gallium oxide heterojunction-based photodetector according to UV wavelength. The graphs shown in FIGS. 17 to 19 are the results of measurements using the silver oxide/β-gallium oxide heterojunction-based photodetector having the thine silver layer of about 20nm thickness under UV at a wavelength of about 254 nm with various light intensities ranging from about 100 to about 1000 $1000\mu W/cm^2$ at zero bias.

Referring to FIGS. 17 to 19 together, as the UV intensity increases, the photocurrent gradually increases because of the higher UV intensity, generating more EHPs. Responsivity, which represents the sensitivity of the photodetector, and detectivity, which is the figure of merit for the smallest detectable signal, were evaluated from the photocurrent according to the light intensity. The responsivity R is given by:

Mathematical equation 5

$$R = \frac{J_{photo} - J_{dark}}{P}$$

where $J_{photo}$ is the photocurrent density, $J_{dark}$ is the dark-current density, and $P$ is the supplied light intensity. The detectivity D is given by

## Mathematical equation 6

$$D = \frac{R}{(2eJ)^{1/2}}$$

where e is the elemental charge and $J$ is the dark-current density.

In summary, both the responsivity and detectivity decrease as the UV intensity increases because, when more EHPs are generated by the higher UV intensity, selfheating is induced in the photodetector, which not only increases the number of charge carriers but also increases the possibility of carrier recombination. The maximum values of responsivity R and detectivity D are 25.65 mA/W and $6.10 \times 10^{11}$ Jones, respectively, for the devices with the 20nm Ag layer. In particular, the responsivity R is higher than those of other reported self-powered DUV photodetectors. It can be confirmed that the rejection ratio of 254 nm (UVC) to 365 nm (UVA) at zero bias under the UV intensity of 1000 $\mu$W/cm$^2$ is $2.47 \times 10^3$.

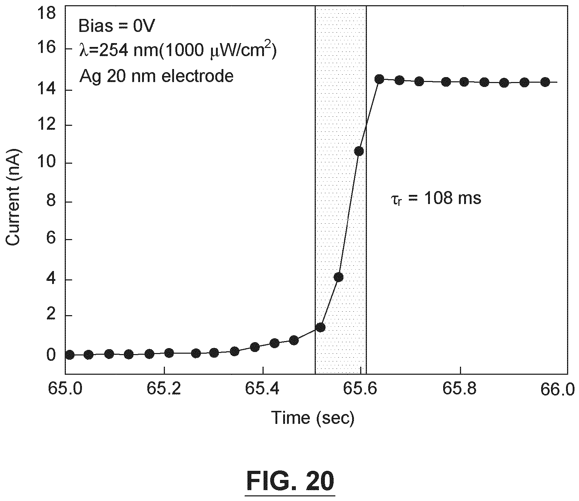

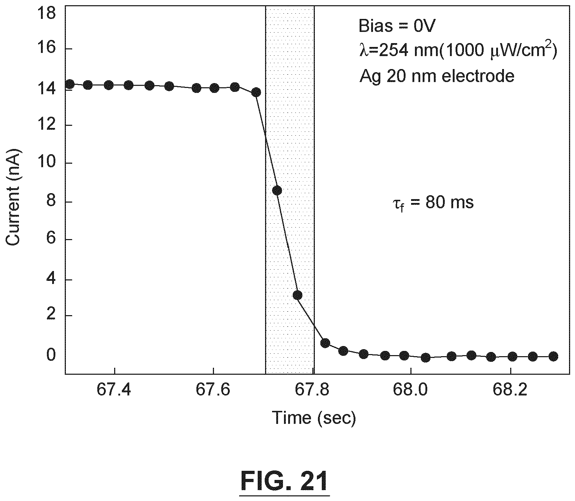

FIG. 20 and FIG. 21 are graphs showing rise time and fall time of the time-dependent photocurrent of the photodetector, respectively

Referring to FIGS. 20 and 21, the response speed of the photodetector is an important factor in evaluating the photodetector. It is determined by the magnitude of the built-in electric field caused by the difference in the band gaps between $Ag_2O$ and $\beta$-$Ga_2O_3$. FIGS. 20 and 21 show the rise and fall times of the $Ag_2O$/$\beta$-$Ga_2O_3$ p-n junction DUV photodetector with the 20nm Ag layer, which was measured using the time-dependent photocurrent characteristics, and each time point was 108ms and 80ms, respectively, under 254 nm UVC light 1000 $\mu$W/cm$^2$ at zero bias.

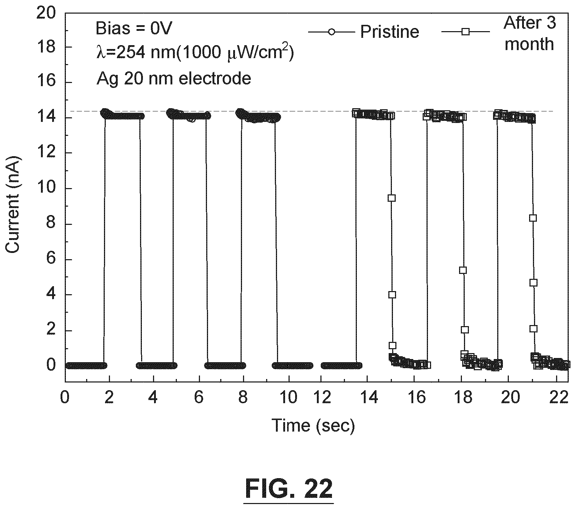

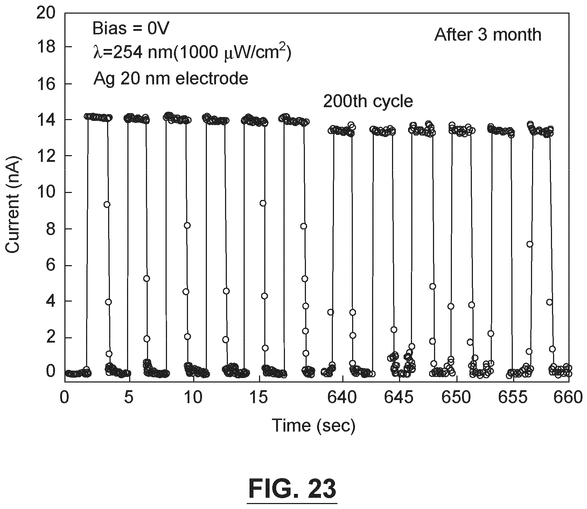

FIG. 22 is a graph showing the results of a photostability test performed on a pristine photodetector and a photodetector stored for three months, and FIG. 23 is a graph showing the results of the photostability test performed on a photodetector stored for three months. The graphs shown in FIGS. 22 and 23 are the results measured using the silver oxide/$\beta$-gallium oxide heterojunction-based photodetector having the silver layer of about 20nm thickness under UV of about 1000$\mu$W/cm$^2$ at zero bias and a wavelength of 254nm.

Referring to FIGS. 22 and 23 together, compared with the pristine photodetector, the photocurrent remained constant even after three months, indicating that it has good long-term stability and consistency in the photoresponse characteristics.

Meanwhile, the photodetector stored for three months exhibited significant stability during repeated on-off operations for 200 cycles. Compared to the photocurrent of about 14.2nA generated in the first cycle, the photocurrent of about 13.8nA was generated after 100 cycles, indicating a decrease of about 2.8%, and the photocurrent of about 13.4nA was generated after 200 cycles, indicating a decrease of about 5.7%. Considering the long storage time, about 5.7% is a relatively small decrease.

Comparative examples

Table 3

| Photodetector | wavelength (nm) | Responsivity (mA/W) | Rise time/decay time | Detectivity (Jones) |
|---|---|---|---|---|
| Graphene/$\beta$-$Ga_2O_3$ | 254 | 10.3 | <30ns/<2.24$\mu$s | - |
| p-SiC/$\beta$-$Ga_2O_3$ | 254 | 10.4 | 11ms/19ms | $8.8 \times 10^9$ |
| CuI/$\beta$-$Ga_2O_3$ | 254 | 8.46 | 97.8ms/28.9ms | $7.75 \times 10^{11}$ |
| CuCrO$_2$/$\beta$-$Ga_2O_3$ | 254 | 0.12 | 0.35s/0.06s | $4.6 \times 10^{11}$ |
| CuGaO$_2$/$\beta$-$Ga_2O_3$ | 254 | 0.03 | 0.26s/0.14s | $0.9 \times 10^{11}$ |
| MoS$_2$/$\beta$-$Ga_2O_3$ | 245 | 2.05 | - | $1.21 \times 10^{11}$ |
| NbSTO/$\beta$-$Ga_2O_3$ | 254 | 2.60 | 0.21s/0.07s | - |
| ZnO/$\beta$-$Ga_2O_3$ | 251 | 9.7 | 100$\mu$s/900$\mu$s | $6.29 \times 10^{12}$ |
| $Ag_2O$/$\beta$-$Ga_2O_3$ | 254 | 25.7 | 108ms/80ms | $6.10 \times 10^{11}$ |

Table 3 presents a comparison of the photoresponse parameters of the $Ag_2O/\beta\text{-}Ga_2O_3$ p-n-junction-based photodetector with the 20nm Ag layer as the top electrode from simple heterojunction DUV self-powered photodetectors based on $\beta\text{-}Ga_2O_3$. The $Ag_2O/\beta\text{-}Ga_2O_3$ DUV self-powered photodetector with the 2 nm Ag layer exhibited a higher responsivity and a higher detectivity than those of other DUV self-powered photodetectors based on simple heterojunctions with $\beta\text{-}Ga_2O_3$. The response speed was also comparable to those of other DUV selfpowered photodetectors. The photodetector with the 20nm thick Ag layer, which has low optical loss owing to its low surface roughness, exhibited the best performance and can be used without any external power supply. Among the DUV photodetectors based on various heterojunctions with $\beta\text{-}Ga_2O_3$, the p-n-junction-based photodetector has higher photoresponsivity and detectivity than other heterojunction-based photodetectors because the interface area induces a built-in electric field, which improves the efficiency of generating photoexcited EHPs. However, in self-powered heterojunction-based photodetectors, since responsivity is relatively low and photogenerated carriers are transported and collected by the presence of the built-in electric field, the response speed rather than the responsivity and detectivity becomes the key parameter.

The above description of the invention is exemplary, and those skilled in the art can understand that the invention can be modified in other forms without changing the technical concept or the essential feature of the invention. Therefore, it should be understood that the above-mentioned embodiments are exemplary in all respects, but are not definitive.

The scope of the invention is defined by the appended claims, not by the above detailed description, and it should be construed that all changes or modifications derived from the meanings and scope of the claims and equivalent concepts thereof are included in the scope of the invention.

**Claims**

1. A method for manufacturing a solar blind photodetector based on a silver oxide/$\beta$-gallium oxide heterojunction, comprising:

   growing a first conductivity type $\beta$-gallium oxide epitaxial layer on a first conductivity type $\beta$-gallium oxide wafer;
   positioning the first conductivity type $\beta$-gallium oxide wafer in a sputtering chamber;
   depositing a second conductivity type silver oxide layer on the first conductivity type $\beta$-gallium oxide epitaxial layer in a mixed atmosphere of an inert gas and an oxygen gas;
   blocking the supply of oxygen gas to the sputtering chamber; and
   depositing a silver layer on the second conductivity type silver oxide layer in the inert gas atmosphere to form a top electrode.

2. The method of claim 1, wherein the second conductivity type silver oxide layer and the silver layer are continuously deposited using a facing target sputtering.

3. The method of claim 1, wherein a flow rate of the oxygen gas is 3 sccm in the depositing the second conductivity type silver oxide layer on the first conductivity type $\beta$-gallium oxide epitaxial layer in the mixed atmosphere of the inert gas and the oxygen gas.

4. The method of claim 1, wherein the silver layer is deposited thicker than a threshold thickness to form a surface uniformly and continuously.

5. The method of claim 4, wherein the silver layer is deposited with a thickness of 20nm to increase a transmittance and decrease a reflectance.

6. The method of claim 1 further comprising performing a post-annealing the first conductivity type $\beta$-gallium oxide wafer on which the top electrode is formed.

7. The method of claim 6, wherein the post-annealing is a rapid heat treatment performed at 100°C to 350°C.

8. A solar blind photodetector based on a silver oxide/$\beta$-gallium oxide heterojunction, comprising:

   a first conductivity type $\beta$-gallium oxide wafer;
   a first conductivity type $\beta$-gallium oxide epitaxial layer, epitaxially grown on a top surface of the first conductivity type $\beta$-gallium oxide wafer;
   a second conductivity type silver oxide layer, deposited on the first conductivity type $\beta$-gallium oxide epitaxial layer in a mixed atmosphere of an inert gas and an oxygen gas;

a silver layer, deposited on the second conductivity type silver oxide layer in the inert gas atmosphere; and a bottom electrode layer in ohmic contact with a bottom surface of the first conductivity type β-gallium oxide wafer.

9. The solar blind photodetector based on a silver oxide/β-gallium oxide heterojunction of claim 8, wherein the silver layer is formed by continuously depositing on the second conductive type silver oxide layer by blocking the supply of oxygen gas to a sputtering chamber after deposition of the second conductive type silver oxide layer.

10. The solar blind photodetector based on a silver oxide/β-gallium oxide heterojunction of claim 8, wherein the second conductive type silver oxide layer has a thickness of 50nm.

11. The solar blind photodetector based on a silver oxide/β-gallium oxide heterojunction of claim 8, wherein the silver layer is deposited with a thickness of 20nm to increase a transmittance and decrease a reflectance.

10

130

120

110

100

140

## FIG. 1

200
Ag₂O layer deposition

210
Ag layer deposition

220
Ag₂O/Ag annealing

## FIG. 2

FIG. 3A

FIG. 3B

## FIG. 3C

## FIG. 3D

FIG. 4

**FIG. 5**

Ag 10 nm
RMS = 0.8 nm

FIG. 6A

Ag 20 nm
RMS = 1.0 nm

FIG. 6B

**Ag 30 nm**
**RMS = 1.1 nm**

## FIG. 6C

**Ag 40 nm**
**RMS = 1.2 nm**

## FIG. 6D

**Ag 10 nm**

# FIG. 6E

FIG. 7

FIG. 8

**FIG. 9**

**FIG. 10**

**FIG. 11**

**FIG. 12**

## FIG. 13

P-type                              N-type

– – Carrier recombination  ▬▬ Carrier transition

## FIG. 14

Vacuum level

$q\Phi_m$   $q\Phi_s$

$E_C$

$E_F$

Ag   $E_V$

Ag$_2$O

Vacuum level

$q\Phi_m$   $q\Phi_s$   $E_C$

$E_F$
$E_V$

Ag

Ag$_2$O

‗ Interfacial
  defect

▬ Ohmic
  contact

Ag/Ag$_2$O layer with Ag 40 nm   Ag/Ag$_2$O layer with Ag 10 nm

## FIG. 15

FIG. 16

FIG. 17

**FIG. 18**

FIG. 19

FIG. 20

Bias = 0V
$\lambda$=254 nm(1000 $\mu$W/cm$^2$)
Ag 20 nm electrode

$\tau_f$ = 80 ms

FIG. 21

FIG. 22

**FIG. 23**

<div align="center">

**INTERNATIONAL SEARCH REPORT**

</div>

| | International application No. |
|---|---|
| | **PCT/KR2023/002577** |

### A. CLASSIFICATION OF SUBJECT MATTER

**H01L 31/18**(2006.01)i; **H01L 31/109**(2006.01)i; **H01L 31/101**(2006.01)i

According to International Patent Classification (IPC) or to both national classification and IPC

### B. FIELDS SEARCHED

Minimum documentation searched (classification system followed by classification symbols)

H01L 31/18(2006.01); H01L 23/02(2006.01); H01L 23/20(2006.01); H01L 31/0304(2006.01); H01L 31/032(2006.01); H01L 31/09(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 심자외선(DUV, deep ultraviolet ray), 검출(detection), 산화은(silver oxide), 산화갈륨(gallium oxide), 이종접합(heterojunction)

### C. DOCUMENTS CONSIDERED TO BE RELEVANT

| Category* | Citation of document, with indication, where appropriate, of the relevant passages | Relevant to claim No. |
|---|---|---|
| A | JUBU, P.R. et al. Development and characterization of MSM UV photodetector based on gallium oxide nanostructures. Sensors and Actuators A: Physical. 06 June 2020, Volume 312, 112141, pp. 1-9. Retrieved from <https://doi.org/10.1016/j.sna.2020.112141>. See pages 1-7, and figure 1. | 1-11 |
| A | WU, C. et al. Vertical $\alpha/\beta$-Ga2O3 phase junction nanorods array with graphene-silver nanowire hybrid conductive electrode for high-performance self-powered solar-blind photodetectors. Materials Today Physics. 21 February 2020, Volume 12, 100193, pp. 1-7. Retrieved from <https://doi.org/10.1016/j.mtphys.2020.100193>. See pages 1-6, and figure 4. | 1-11 |
| A | KR 10-2018-0129698 A (AJOU UNIVERSITY INDUSTRY-ACADEMIC COOPERATION FOUNDATION) 05 December 2018 (2018-12-05) See claims 1-8, and figure 1. | 1-11 |
| A | JP 2009-200222 A (NIPPON LIGHT METAL CO., LTD. et al.) 03 September 2009 (2009-09-03) See claims 1-9, and figure 1. | 1-11 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **26 May 2023** | **26 May 2023** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2023/002577**

**C.    DOCUMENTS CONSIDERED TO BE RELEVANT**

| Category* | Citation of document, with indication, where appropriate, of the relevant passages | Relevant to claim No. |
|---|---|---|
| A | US 2017-0170345 A1 (MERCK PATENT GMBH.) 15 June 2017 (2017-06-15)<br>See claims 1-6, and figure 1. | 1-11 |

Form PCT/ISA/210 (second sheet) (July 2022)

38

## INTERNATIONAL SEARCH REPORT
### Information on patent family members

| | International application No. |
| --- | --- |
| | **PCT/KR2023/002577** |

| Patent document cited in search report | | | Publication date (day/month/year) | Patent family member(s) | | | Publication date (day/month/year) |
| --- | --- | --- | --- | --- | --- | --- | --- |
| KR | 10-2018-0129698 | A | 05 December 2018 | KR | 10-1946205 | B1 | 17 April 2019 |
| JP | 2009-200222 | A | 03 September 2009 | | None | | |
| US | 2017-0170345 | A1 | 15 June 2017 | CN | 105934535 | A | 07 September 2016 |
| | | | | EP | 3099838 | A1 | 07 December 2016 |
| | | | | JP | 2017-506000 | A | 23 February 2017 |
| | | | | KR | 10-2016-0118286 | A | 11 October 2016 |
| | | | | US | 10431704 | B2 | 01 October 2019 |
| | | | | WO | 2015-113737 | A1 | 06 August 2015 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **WATERHOUSE et al.** The thermal decomposition of silver (I, III) oxide: A combined XRD, FT-IR and Raman spectroscopic study. *Chemistry Physical Chemistry Chemical Physics*, 2001, vol. 3, 3838-3845